# EUROPEAN PATENT APPLICATION

(11) **EP 2 511 739 A2**
(43) Date of publication of application: **17.10.2012**
(21) Application number: 12164069.2
(22) Date of filing: 13.04.2012
(51) Int. Cl.: G02B 5/20

(54) **Light-tuning method**

(30) Priority: 14.04.2011 TW 100113013
(71) Applicant: Lextar Electronics Corp., 30075 Hsinchu (TW)
(72) Inventor: Cai, Pei-Song, 357 Miaoli County (TW); Tien, Yun-Yi, 300 Hsinchu City (TW); Lin, Tzu-Pu, 114 Taipei City (TW)
(74) Representative: von Kreisler Selting Werner

(57) **Abstract**

A light-tuning method is provided. In the method, a filter material is first selected for filtering out unwanted light of a specific wavelength to obtain a transmittance spectrum. The transmittance spectrum is multiplied by an eye sensitivity function to obtain a filtered spectrum. The filtered spectrum has a wavelength range between 450nm and 650nm. According to a full width at half maximum (FWHM) wavelength range of the filtered eye sensitivity function, a phosphor is selected and a light-emitting spectrum of the phosphor is determined so that between the light-emitting spectrum of the phosphor and the filtered eye sensitivity function is an optimal matching degree.

## Description

This application claims the benefit of Taiwan application Serial No. 100113013, filed April 14, 2011, the subject matter of which is incorporated herein by reference.

### BACKGROUND OF THE INVENTION

### Field of the Invention

The invention relates in general to a light-tuning method, and more particularly to a light-tuning method capable of filtering out light having a specific wavelength range and increasing light-emitting efficiency.

### Description of the Related Art

Lighting provided by a light-emitting diode (LED) is applicable to various types of lighting structures, which are mostly planar lighting devices or tubal lighting devices. In a planar lighting device, a light-guide plate is provided for refracting beams from an LED light source coming from a side upwards to generate planar beams. Beams of an LED light source in a tubal lighting device are directly emitted outwards from a light-emitting surface of the LED light source, and a lamp cover of a tubal light device is shaped as a curve to replace a conventional fluorescent tube.

However, certain special fluorescent tubes with a specific wavelength have a large driving power and a short lifespan, and thus a high replacement frequency and high costs. Further, surfaces of the special fluorescent tubes are enveloped by a special plastic film. When the fluorescent tubes are in use, light having ultraviolet wavelengths is generated such that the special plastic films are aged due to prolonged exposure to the ultraviolet light. Therefore, during a manufacturing process, the aged plastic films are incapable of filtering out wavelengths affecting exposure reaction, resulting in defective light-sensing materials and a degraded manufacturing yield rate.

Further, light-emitting efficiency of phosphor is often reduced due to partial energy absorption as being filtered by a light filter such that overall brightness of the lighting device is depreciated. To increase the brightness, it infers that higher power consumption of the lighting device is required to hence increase production costs. Meanwhile, thermal energy of the lighting device is also increased to again shorten the lifespan of the lighting device.

### SUMMARY OF THE INVENTION

The invention is directed to a light-tuning method, which is capable of filtering out light having a specific wavelength range and selecting phosphor according to a matching degree between a filtered eye sensitivity function and a light-emitting spectrum of the phosphor, thereby obtaining an optimal light-emitting spectrum.

According to an aspect of the present invention, a light-tuning method is provided. In the method, a filter material for filtering out unwanted light having a specific wavelength range is first selected. The spectrum of the filter material is equivalent to a transmittance spectrum, which may be a high-pass, low-pass or band-pass transmittance spectrum. An eye sensitivity function is multiplied by the transmittance spectrum to obtain a filtered eye sensitivity function. A wavelength range of the filtered eye sensitivity function is between 450nm and 650nm. According to a full width at half maximum (FWHM) wavelength range of the filtered eye sensitivity function, a phosphor is selected so that between a light-emitting spectrum of the phosphor and the filtered eye sensitivity function is an optimal matching degree.

In one embodiment, a peak wavelength of the filtered spectrum is λ1, a peak wavelength of the light-emitting spectrum is λ2, and an absolute value |λ2-λ1| is smaller than a half of the FWHM wavelength range of the filtered eye sensitivity function.

The above and other aspects of the invention will become better understood with regard to the following detailed description of the preferred but non-limiting embodiments. The following description is made with reference to the accompanying drawings.

### BRIEF DESCRIPTION OF THE DRAWINGS

FIG. 1 is a diagram of a wavelength a product of multiplication from T(A) and E(λ).

FIG. 2 is a diagram comparing light-emitting spectra and filtered spectra of phosphors.

### DETAILED DESCRIPTION OF THE INVENTION

A light-tuning method according to one embodiment utilizes an eye sensitivity function as basis for light-tuning to analyze characteristics of a filter material and to select a light-emitting spectrum of a phosphor, so that between the light-emitting spectrum of the selected phosphor and the filtered eye sensitivity function is an optimal matching degree.

The light-tuning method according to the embodiment is applicable to a light source of a tubal lamp or a planar lamp. The light source in the lamp is formed by a material of different components, e.g., a blue light emitting diode (LED) based on indium gallium nitride (InGaN) / gallium nitride (GaN) / aluminum gallium nitride (AlGaN) added with yellow phosphor, so as to allow the blue light to stimulate the yellow phosphor to produce yellow light. Alternatively, a green LED is added with a red phosphor, so as to allow the green light to stimulate the red phosphor to produce red light. Some common light-blending techniques for producing white light include a blue LED added with yttrium aluminum garnet Y₃Al₅O₁₂: Ce (YAG) by Nichia, and an blue LED added with terbium aluminum garnet Tb₃A₁₅O₁₂:Ce (TAG) by OSRAM or an ultraviolet LED added with red, blue and green phosphors. However, the conventional light-blending techniques are still faced with issues of unsatisfactory light-emitting efficiency and limited choices of phosphors. Further, after the light produced by the above approaches a light filter having a certain wavelength range, light flux per unit watt (approximately 50Lm/W) is drastically reduced as a part of energy is absorbed by the light filter, and so the overall brightness of the lighting device yet remains unenhanced.

Through a light-tuning method to be described below, optimal light energy is obtained for enhancing the overall brightness of a lighting device. The method includes Steps S10 to S30. In Step S10, a filter material is selected. The light filter material is for filtering out unwanted light having a specific wavelength range to obtain a transmittance spectrum T(A). In one embodiment, the filter material is for filtering out light having a wavelength smaller than 500nm. In Step S20, an eye sensitivity function E(A) is multiplied by the transmittance spectrum T(A) to obtain a filtered eye sensitivity function F (λ), i.e., F(λ)=T(λ)*E(λ). The wavelength range of the filtered eye sensitivity function F(A) is between 450nm and 650nm. In Step S30, according to a full width at half maximum (FWHM) wavelength range of the filtered eye sensitivity function, a phosphor is selected so that between the light-emitting spectrum of the phosphor and the filtered eye sensitivity function is an optimal matching degree.

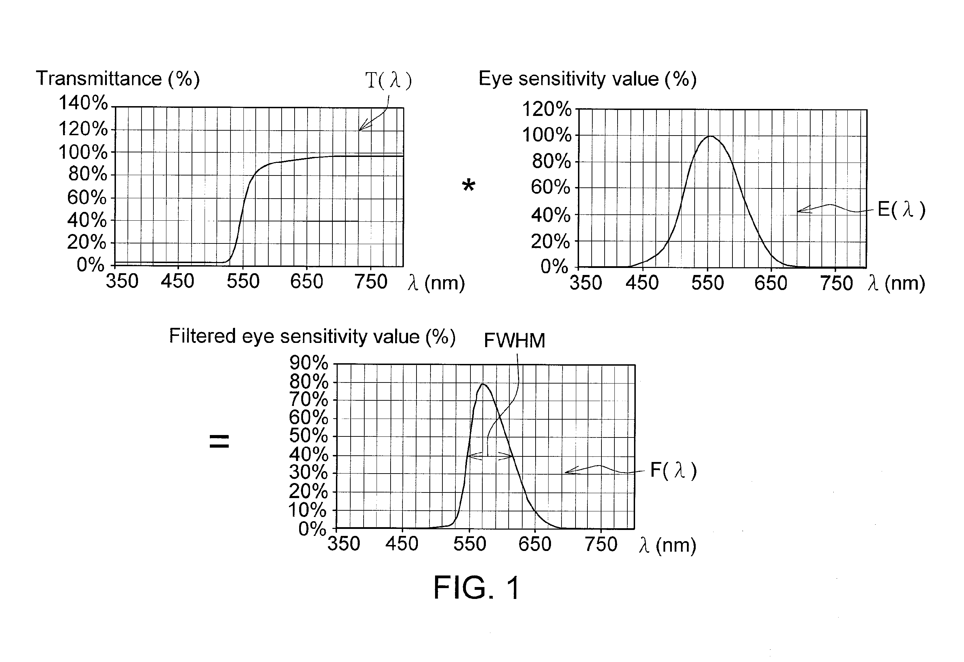

FIG. 1 shows a diagram of a wavelength range of the filtered eye sensitivity function F(λ) obtained by multiplying the eye sensitivity function E(A) by the transmittance spectrum T(A), i.e., T(λ)*E(λ)= F(A). In an embodiment, the light having a wavelength range below 550nm in the transmittance spectrum T(λ) may be filtered out, and only the light having a wavelength range over 550nm can pass through the light filter material.

The eye sensitivity function E(A) is multiplied by the transmittance spectrum T(λ) to get a wavelength range from the filtered eye sensitivity function F(λ). Thus, the wavelength range is calculated according to the eye sensitivity function. In the eye sensitivity function E(A), an eye sensitivity value is different for different wavelength. The peak is approximately at 555nm, and the wavelength range is approximately between 380nm and 780nm. Colored light exceeding the wavelength range is invisible to the eye and hence has an eye sensitivity of almost zero. Therefore, in the filtered eye sensitivity function F(A) obtained from multiplying the eye sensitivity function E(A) with the transmittance spectrum T(λ) in FIG. 1, the wavelength range of approximately between 450nm and 650nm is capable of filtering out ultraviolet light having a wavelength of smaller than 450nm and visible light having a wavelength of greater than 650nm, so that the wavelength range of the filtered eye sensitivity function F(A) is between 450nm and 650nm. In this embodiment, the wavelength range of the filtered eye sensitivity function F(λ) is between 500nm and 650nm, and the FWHM wavelength range of the filtered eye sensitivity function F(λ) is between 550nm and 610nm, i.e., the width of the FWHM wavelength range is about 60nm.

It should be noted that the FWHM wavelength range of the filtered eye sensitivity function F(A) changes according to different filter materials, and is thus not limited to being between 550nm and 610nm. In an alternatively embodiment, a peak of the filtered eye sensitivity function F(A) is 555nm that is close to a peak of the eye sensitivity function, and the FWHM wavelength range of the filtered eye sensitivity function F(A) is approximately between 505nm and 605nm. That is, the maximum width of the FWHM filtered eye sensitivity function F(λ) is about 100nm and is greater than the actual wavelength 60nm.

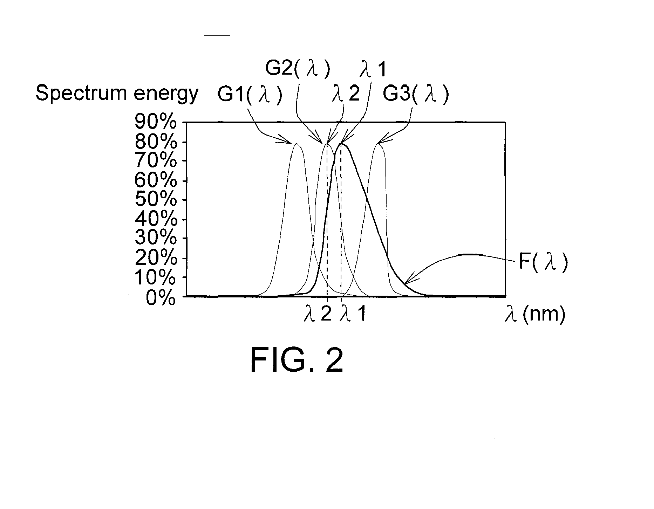

FIG. 2 shows a diagram comparing light-emitting spectra of phosphors and the filtered eye sensitivity function. In Step S30, when the selected phosphor is respectively G1(λ), G2(λ) and G3(λ), as observed from FIG. 2, since the light-emitting spectrum G2(λ) is closer to the filtered eye sensitivity function F(λ) than the light-emitting spectra G1(λ) and G3(λ), the eye sensitivity value corresponding to the light-emitting spectrum G2(λ) is larger than the eye sensitivity values corresponding to the light-emitting spectra G1(λ) and G3(λ). Therefore, according to the FWHM wavelength range of the filtered eye sensitivity function F(λ), an ideal phosphor is selected and the light-emitting spectrum of the phosphor is also determined to optimize the light flux per unit watt to as high as over 100Lm/W for enhancing the overall brightness of the lighting device.

In one embodiment, for example, the peak wavelength of the filtered spectrum F(λ) is λ1, and the peak wavelength of the light-emitting spectrum G2(λ) is λ2. When the absolute value |λ2-λ1|<1/2FWHM, the optimized light-emitting spectrum G2(λ) may be obtained. For example, when the wavelength width of the FWHM wavelength range is 60nm, the absolute value |λ2-λ| is smaller than 30nm; when the wavelength width of the FWHM wavelength range is 100nm, the absolute value |λ2-λ1| is smaller than 50nm.

In one embodiment, the filter material is doped to a molding material or coated on a molding material to form a light filter. For example, the phosphor is a yellow phosphor molded in an LED package structure. For example, the LED is a blue LED for stimulating the yellow phosphor to produce yellow light, and the spectrum of the produced yellow light blended with blue light is a white light spectrum. In FIG. 2, the wavelength range of the filtered eye sensitivity function (λ) is approximately between 500nm and 650nm, and has a peak at around 555nm. Therefore, given that the peak and bandwidth of the light-emitting spectrum of the phosphor are close to the filtered eye sensitivity function, the overall light-emitting efficiency is higher under the same power.

As illustrated with the above description, the light-tuning according to the embodiment is capable of filtering out unwanted light having a specific wavelength range (such as ultraviolet light), so as to prevent exposure reactions of a light-sensing material and thus to increase a manufacturing yield rate. Further, colored light having a wavelength range between 450nm and 650nm has an eye sensitivity value greater than colored light in other wavelengths such that the eye senses different intensities for colored light emitted under a same power. Thus, without increasing power consumption (i.e., while being power-saving), an ideal phosphor is selected by the light-tuning method according to the embodiment, so that between the light-emitting spectrum of the selected phosphor and the filtered eye sensitivity function is an optimal matching degree for rendering an optimized light-emitting spectrum.

While the invention has been described by way of example and in terms of the preferred embodiments, it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A light-tuning method, comprising:
selecting a filter material for filtering out light having a specific wavelength range to obtain a transmittance spectrum;
multiplying an eye sensitivity function by the transmittance spectrum to obtain a filtered eye sensitivity function, the filtered eye sensitivity function having a wavelength range between 450nm and 650nm; and
selecting a phosphor according to a full width at half maximum (FWHM) wavelength range of the filtered eye sensitivity function, and determining a light-emitting spectrum of the phosphor.

2. The method according to claim 1, wherein the specific wavelength range is smaller than 500nm.

3. The method according to claim 1, wherein the filter material is doped in a molding material or coated on a molding material to form a light filter.

4. The method according to claim 1, wherein the phosphor is molded in a light-emitting diode (LED) to obtain a white light spectrum.

5. The method according to claim 4, wherein the phosphor comprises a yellow phosphor.

6. The method according to claim 4, wherein the LED comprises a blue LED.

7. The method according to claim 1, wherein a peak wavelength of the filtered eye sensitivity function is λ1, a peak wavelength of the light-emitting spectrum is λ2, and an absolute value |λ2-λ1| is smaller than a half of the FWHM wavelength range of the filtered eye sensitivity function.

8. The method according to claim 1, wherein the transmittance spectrum is a high-pass, low-pass or band-pass transmittance spectrum.
